# EUROPÄISCHE PATENTSCHRIFT

(11) **EP 2 600 705 B1**
(45) Veröffentlichungstag und Bekanntmachung des Hinweises auf die Patenterteilung: **07.08.2019**
(21) Anmeldenummer: 12192925.1
(22) Anmeldetag: 16.11.2012
(51) Int. Cl.: H05K 7/14, H01R 13/645

(54) **Separates Zubehörelement für eine Steuerungsvorrichtung**
Separate accessory element for a control device
Élément accessoire séparé pour un dispositif de commande

(30) Priorität: 01.12.2011 DE 102011055920
(43) Veröffentlichungstag der Anmeldung: 05.06.2013
(73) Patentinhaber: Pilz GmbH & Co. KG, 73760 Ostfildern (DE)
(72) Erfinder: Cech, Markus, 73760 Ostfildern (DE); Godau, Thorsten, 73760 Ostfildern (DE)
(74) Vertreter: Witte, Weller & Partner Patentanwälte mbB

(56) Entgegenhaltungen:
- EP-A1- 0 959 533
- EP-A1- 1 119 229
- DE-A1- 2 807 017

## Beschreibung

Die Erfindung betrifft ein separates Zubehörelement für eine zumindest ein erstes und zweites Modulteil aufweisende Steuerungsvorrichtung zum automatisierten Steuern einer technischen Anlage, mit einem ersten Teil mit einer Kodierleiste eines Kodiermittels zum Definieren einer bestimmten mechanischen Kodierung für zusammengehörende erste und zweite Modulteile, und mit einem zweiten Teil zum Greifen des separaten Zubehörelements, wobei die Kodierleiste mindestens einen darin ausgeformten Kodierhohlraum aufweist, und wobei zwischen dem ersten Teil und dem zweiten Teil mindestens eine Trennstelle zum Trennen des ersten Teils und des zweiten Teils angeordnet ist. Ein solches Zubehörteil ist aus EP 1 119 229 A1 bekannt.

Die Erfindung betrifft ferner ein separates Zubehörelement für eine zumindest ein erstes und zweites Modulteil aufweisende Steuerungsvorrichtung zum automatisierten Steuern einer technischen Anlage, mit einem ersten Teil mit Kodiereinsatzstücken eines Kodiermittels zum Definieren einer bestimmten mechanischen Kodierung für zusammengehörende erste und zweite Modulteile, und mit einem zweiten Teil zum Greifen des separaten Zubehörelements, wobei die Kodiereinsatzstücke jeweils in einen Kodierhohlraum einer Kodierleiste einsetzbar sind, wobei zwischen dem ersten Teil und dem zweiten Teil mindestens eine Trennstelle zum Trennen des ersten Teils und des zweiten Teils angeordnet ist. Ein solches Zubehörteil ist aus EP 0 959 533 A1 bekannt.

Die vorliegennde Erfindung betrifft ferner einen Modulteil-Bausatz für eine Steuerungsvorrichtung zum automatisierten Steuern einer technischen Anlage, mit einem solchen separaten Zubehörelement.sowie eine Steuerungsvorrichtung zum automatisierten Steuern einer technischen Anlage, mit einem solchen Modulteil-Bausatz.

Ein separates Zubehörelement und ein Modulteil-Bausatz dieser Art sind ferner aus US 6,485,336 B1 bzw. EP 1 052 883 A2 bekannt.

Eine Steuerungsvorrichtung im Sinne der vorliegenden Erfindung kann beispielsweise eine modulare Steuerungsvorrichtung für eine konfigurierbare oder programmierbare Steuerung sein. Die Steuerungsvorrichtung kann insbesondere mehrere Module mit jeweils mindestens einem ersten und einem zweiten Modulteil umfassen. Es kann eine konfigurierbare Steuerung sein, wie beispielsweise jene, die die Anmelderin der vorliegenden Erfindung unter der Marke PNOZ® vertreibt, oder eine programmierbare Steuerung, wie beispielsweise jene, die die Anmelderin der vorliegenden Erfindung unter der Marke PSS® vertreibt, oder eine dieser ähnliche. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Ein Modulteil-Bausatz im Sinne der vorliegenden Erfindung weist Kodiermittel zum Definieren einer bestimmten mechanischen Kodierung für zusammengehörende erste und zweite Modulteile auf. Durch solche Kodiermittel wird verhindert, dass nicht zusammengehörende erste und zweite Modulteile zusammengesetzt werden können. Ein solches fehlerhaftes Zusammensetzen von nicht zusammengehörenden ersten und zweiten Modulteilen kann gravierende Folgen haben, bspw. das Zusammenführen verschiedenere Spannungspotentiale. Im schlimmsten Fall werden die Modulteile oder die Steuerungsvorrichtung zerstört.

Bei einer ersten Art der mechanischen Kodierung wird die Kodierung durch die Form bzw. den Querschnitt eines Kodiervorsprungs und seines entsprechenden Kodierhohlraums definiert, wobei der Kodierhohlraum eine der Form bzw. dem Querschnitt des Kodiervorsprungs entsprechende Form bzw. Querschnitt aufweist. Der Kodiervorsprung und sein entsprechender Kodierhohlraum werden dann nach dem Schlüssel-Schlüsselloch-Prinzip zusammengesteckt. Es kann so eine große Anzahl von unterschiedlichen Kodierungen erreicht werden, abhängig von der Anzahl der verschiedenen Formen bzw. Querschnitte. Jedoch werden der Kodiervorsprung und sein entsprechender Kodierhohlraum in unterschiedlichen Formen benötigt, wodurch die Fertigung sowie die Vorratshaltung teurer und schwieriger wird. Da eine Kodierung dieser Art vom Hersteller festgelegt wird, kann vermieden werden, dass der Endbenutzer die Kodierung fehlerhaft oder gar nicht vornimmt. Eine solche erste Art der Kodierung ist zum Beispiel in der zuvor genannten US 6,485,336 B1 bzw. EP 1 052 883 A2 offenbart.

Bei einer zweiten Art der mechanischen Kodierung sind mehrere Kodiervorsprünge und mehrere entsprechende Kodierhohlräume vorgesehen und die Kodierung wird durch die momentane Anordnung von Kodiereinsatzstücken in den Kodierhohlräumen definiert. Auch auf diese Weise kann eine große Anzahl von unterschiedlichen Kodierungen erreicht werden, abhängig von der Anzahl der Kodierhohlräume bzw. Kodiervorsprünge. Die Kodierleiste und die Kodiervorsprünge müssen in nur einer Form bzw. Art hergestellt werden, wodurch die Fertigung sowie die Vorratshaltung billiger und einfacher wird. Bei einer solchen Art der Kodierung kann der Endbenutzer die Kodierung definieren oder verändern. Eine solche Art der Kodierung ist zum Beispiel aus der US 6,142,592 bzw. EP 0 959 533 A1 bekannt. Auch die DE 38 30 187 A1 offenbart eine solche Art der Kodierung.

Bei dem separaten Zubehörelement des Standes der Technik wird jedoch viel Material benötigt, das nach dem Ansetzen bzw. Einsetzen des zusammengesetzten Kodierelements bzw. Kodiermittels an das Modulteil nicht mehr benötigt wird und daher oft weggeworfen wird.

Vor diesem Hintergrund ist es eine Aufgabe der vorliegenden Erfindung ein separates Zubehörelement und einen Modulteil-Bausatz der eingangs genannten Art anzugeben, die eine erhöhte Umweltfreundlichkeit aufweisen..

Gemäß der Erfindung wird diese Aufgabe durch ein separates Zubehörelement der eingangs genannten Art bzw. einen Modulteil-Bausatz der eingangs genannten Art gelöst, wobei der zweite Teil des separaten Zubehörelements ein Werkzeug mit einem Werkzeuggriffabschnitt und einer Schraubendreherklinge aufweist.

Das neue separate Zubehörelement weist also ein Werkzeug auf. Somit ist der zweite Teil zum Greifen des Zubehörelements kein Abfall, sondern hat die spezielle Funktion eines Werkzeugs. Dadurch wird weniger Abfall erzeugt und somit eine erhöhte Umweltfreundlichkeit bereitgestellt. Das Werkzeug kann insbesondere für die Modulteile verwendet werden, bspw. bei der Installation oder wenn der Endbenutzer die bestimmte Kodierung definiert. Aber auch nach der Installation bzw. Definition der mechanischen Kodierung kann das Werkzeug weiter verwendet werden.

Insgesamt ermöglichen das neue separate Zubehörelement und der neue Modulteil-Bausatz daher eine erhöhte Umweltfreundlichkeit.

In einer bevorzugten Ausgestaltung sind die Kodierhohlräume jeweils zur Aufnahme eines Kodiereinsatzstückes ausgebildet. Die bestimmte Kodierung ist insbesondere durch die momentane Anordnung der Kodiereinsatzstücke in den Kodierhohlräumen definiert.

In dieser Ausgestaltung ist die Kodierung veränderbar. Das Kodiermittel wird durch die Kodierleiste, mit der momentanen Anordnung der Kodiereinsätze, und entsprechenden Kodiervorsprüngen gebildet. Insbesondere kann die Kodierung durch den Endbenutzer vorgenommen werden. Es wird somit eine flexiblere Kodierung bereitgestellt im Vergleich zu einer Kodierung der ersten Art, wie oben beschrieben. Zudem muss nur eine Form bzw. Art von Kodierleiste hergestellt werden, wodurch die Fertigung und Lagerhaltung billiger und einfacher wird.

Weiterhin kann bei dieser Art der Kodierung durch Verwendung der Kodierleiste als separates Element eine erhöhte Modularität bereitgestellt werden. Beispielsweise muss nur eine Gehäusebauform vorgesehen werden, unabhängig davon, ob das Modulteil mit oder ohne mechanische Kodierung verwendet wird. Weiterhin wird eine erhöhte Sauberkeit bzw. weniger Schmutzablagerungen während der Fertigung, der Lagerhaltung und/oder des Transports des Modulteils bereitgestellt, da das Gehäuse des Modulteils weniger Hohlräume aufweist, in denen sich Schmutz ablagern kann.

In einer weiteren Ausgestaltung weist das separate Zubehörelement weiterhin die Kodiereinsatzstücke auf. In dieser Ausgestaltung ist insbesondere zwischen dem zweiten Teil und den Kodiereinsatzstücken mindestens eine Trennstelle zum Trennen des zweiten Teils und der Kodiereinsatzstücke vorgesehen. Insbesondere kann zwischen dem zweiten Teil und jedem Kodiereinsatzstück eine Trennstelle vorgesehen sein.

In dieser Ausgestaltung sind die Kodierleiste und Kodiereinsatzstücke in einem Element integriert. Es wird somit die Gefahr des Verlustes eines Teils des Kodiermittels verringert. Des Weiteren wird die Handhabung der meist sehr klein ausgestalteten Kodiereinsatzstücke bzw. der Kodierleiste erleichtert.

In einer weiteren Ausgestaltung weist das zweite Teil mindestens einen weiteren Werkzeugkopf auf.

In dieser Ausgestaltung können die verschiedenen Werkzeugköpfe verschiedene Funktionen erfüllen. Der zweite Teil des separaten Zubehörelements erfüllt somit einen doppelten Nutzen. Insbesondere können die Werkzeugköpfe dazu ausgebildet sein in verschiedene Elemente der Modulteile einzugreifen. Beispielsweise kann der eine Werkzeugkopf in ein Teil des ersten Modulteils eingreifen und der andere Werkzeugkopf kann in ein Teil des zweiten Modulteils eingreifen.

In einer weiteren Ausgestaltung ist der zweite Teil in Form einer Platte ausgebildet. Unter einer Platte ist insbesondere ein Element oder Teil zu verstehen, dessen Höhe sehr klein im Vergleich zu seiner Breite und Tiefe ist.

In dieser Ausgestaltung wird anstatt eines konventionellen massiven, meist zylinderförmigen, Werkzeuggriffs eine Platte verwendet. Bei der Herstellung des separaten Zubehörelements wird somit Material gespart. Dadurch wird die Umweltfreundlichkeit weiter erhöht.

In einer weiteren Ausgestaltung ist ein Befestigungsmittel vorgesehen, mittels dessen die Kodierleiste an seinem Modulteil lösbar befestigbar ist.

In dieser Ausgestaltung wird durch die lösbare Befestigung der Kodierleiste eine erhöhte Flexibilität bereitgestellt. Beispielsweise kann die Kodierleiste auch wieder entfernt werden, wenn keine mechanische Kodierung erwünscht ist. Insbesondere kann die Kodierleiste das Befestigungsmittel umfassen, beispielsweise in Form einer Nase auf den zwei entgegengesetzten Enden der Kodierleiste, wobei die Nasen jeweils in eine Nut in dem Gehäuse des Modulteils eingreifen können.

In einer weiteren Ausgestaltung ist der Werkzeugkopf ausgebildet in ein Befestigungsmittel an einem der Modulteile einzugreifen. In einer Variante ist das Befestigungsmittel insbesondere das Befestigungsmittel, mittels dessen die Kodierleiste an seinem Modulteil lösbar befestigt ist.

In dieser Ausgestaltung hat das Werkzeug einen Nutzen an den Modulteilen selber. Wenn der Endbenutzer die Installation der Steuerungsvorrichtung vornimmt, kann er das Werkzeug beispielweise dazu benutzen Leitungen oder Kabel an externen Anschlüssen des Modulteils bzw. Moduls anzuschließen.

In einer weiteren Ausgestaltung ist der Werkzeugkopf ausgebildet zum Entfernen der Kodierleiste von seinem Modulteil und/oder zum Entfernen des Kodiereinsatzstückes aus seinem Kodierhohlraum ausgebildet.

In dieser Ausgestaltung hat das Werkzeug einen Nutzen für die mechanische Kodierung der Modulteile.

In einer weiteren Ausgestaltung weist der zweite Teil ein Durchgangsloch auf.

In dieser Ausgestaltung kann der Endbenutzer das Werkzeug an seinem Schlüsselbund montieren. Es wird so vermieden, dass das Werkzeug verloren geht. Eine verbesserte Handhabung wird so bereitgestellt. Gleichzeitig wird weiter Material gespart, wodurch die Umweltfreundlichkeit weiter erhöht wird.

In einer weiteren Ausgestaltung ist das separate Zubehörelement in einem Stück spritzgegossen.

In dieser Ausgestaltung wird eine einfachere und kostengünstigere Herstellung bereitgestellt. Es wird nur eine Spritzgussform benötigt.

In einer weiteren Ausgestaltung ist der mindestens eine Kodiervorsprung integral mit dem Gehäuse ausgebildet.

In dieser Ausgestaltung wird die Handhabung für den Endbenutzer vereinfacht. Der Kodiervorsprung bzw. die Kodiervorsprünge sind in dieser Ausgestaltung nicht als separates Element ausgebildet. Insbesondere können die Kodiervorsprünge integral mit dem billigeren der beiden Modulteile ausgebildet sein. Bei einem fehlerhaften Abtrennen eines Kodiervorsprungs muss dann lediglich ein billiges Teil weggeworfen werden.

In einer weiteren Ausgestaltung weist das Gehäuse des Modulteils mit der Kodierleiste eine Aussparung zur Aufnahme der Kodierleiste auf.

In dieser Ausgestaltung wird Kodierleiste also in das Gehäuse des Modulteils eingelassen bzw. eingesetzt. Es kann so eine ebene Grenzfläche zwischen den Modulteilen bereitgestellt bzw. ermöglicht werden. Insbesondere kann ein Befestigungsmittel vorgesehen sein, mittels dessen die Kodierleiste in der Aussparung lösbar befestigbar ist.

In einer weiteren Ausgestaltung weist das erste Modulteil eine in dem ersten Gehäuse angeordneten Elektronik oder Signalverarbeitungseinheit auf und/oder das zweite Modulteil weist an dem zweiten Gehäuse zumindest einen externen Anschluss zum Anlegen eines Signals oder einer Spannung auf.

In dieser Ausgestaltung kann eine optimale Verteilung von unterschiedlichen Funktionen auf die Modulteile bereitgestellt werden. Insbesondere kann hiermit dem ersten Modulteil die Funktion eines Elektronikmodulteils und dem zweiten Modulteil die Funktion eines Anschlussmodulteils zugewiesen werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in den Zeichnungen dargestellt und werden in der nachfolgenden Beschreibung näher erläutert. Es zeigen:
- Fig. 1: eine perspektivische Darstellung eines ersten Ausführungsbeispiels des separaten Zubehörelements;
- Fig. 2: eine perspektivische Darstellung eines Ausführungsbeispiels des ersten und zweiten Modulteils;
- Fig. 3: eine perspektivische Darstellung eines zweiten Ausführungsbeispiels des separaten Zubehörelements;
- Fig. 4: eine perspektivische Darstellung eines dritten Ausführungsbeispiels des separaten Zubehörelements;
- Fig. 5: eine perspektivische Darstellung des Ausführungsbeispiels des ersten und zweiten Modulteils mit Kodierleiste im nicht-eingesetzten Zustand;
- Fig. 6: eine perspektivische Darstellung des Ausführungsbeispiels des ersten und zweiten Modulteils mit Kodierleiste im eingesetzten Zustand;
- Fig. 7: eine perspektivische Darstellung eines Ausführungsbeispiels des ersten und zweiten Modulteils in der zusammengesetzten Anordnung; und
- Fig. 8: eine perspektivische Darstellung des ersten Modulteils des Ausführungbeispiels;
- Fig. 9: eine perspektivische Darstellung eines Ausführungsbeispiels eines Moduls mit einem ersten, zweiten und dritten Modulteil;
- Fig. 9a: eine entsprechende Querschnittsansicht des in Fig. 9 gezeigten Moduls; und
- Fig. 10: eine vereinfachte Darstellung einer technischen Anlage mit einem Ausführungsbeispiel der Steuerungsvorrichtung.

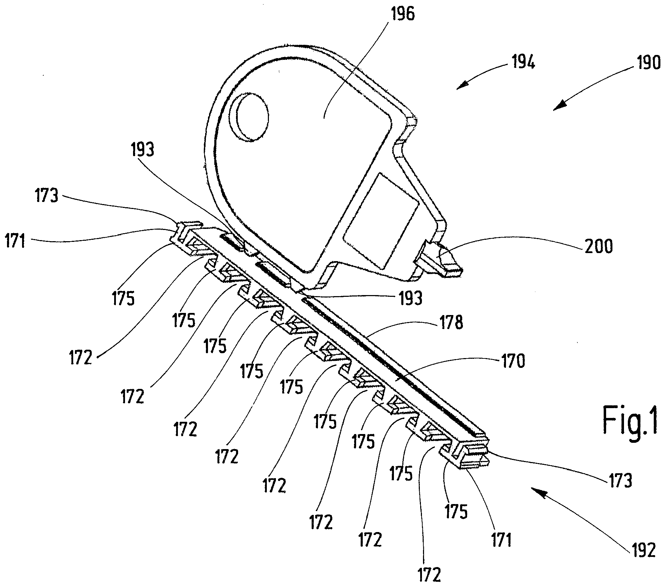

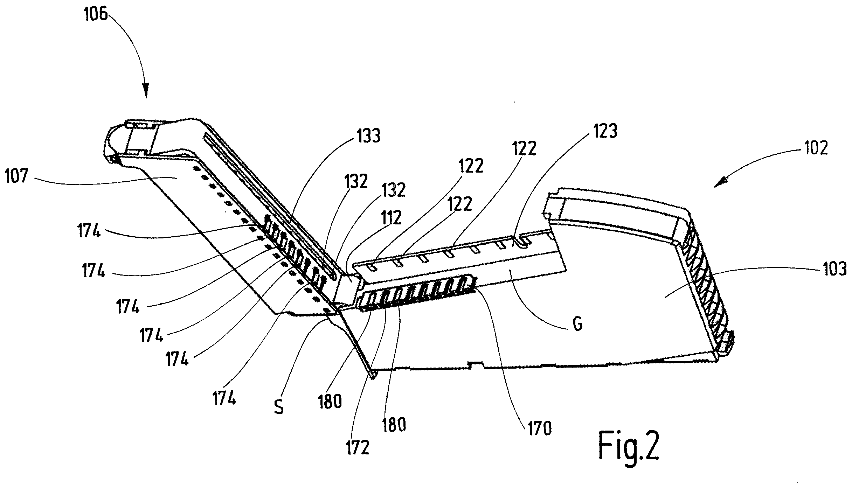

Fig. 1 zeigt eine perspektivische Darstellung eines ersten Ausführungsbeispiels des separaten Zubehörelements 190 für eine zumindest ein erstes und zweites Modulteil aufweisende Steuerungsvorrichtung zum automatisierten Steuern einer technischen Anlage. Fig. 2 zeigt eine perspektivische Darstellung eines Ausführungsbeispiels des ersten Modulteils 102 und zweiten Modulteils 106. Das separate Zubehörelement 190 (Fig. 1) und das erste und zweite Modulteil 102, 106 (Fig. 2) bilden zusammen einen Modulteil-Bausatz.

Das separate Zubehörelement 190 hat bzw. ist unterteilt in einen ersten Teil 192 und einen zweiten Teil 194 zum Greifen des separaten Zubehörelements 190. Der erste Teil 192 hat bzw. ist eine Kodierleiste 170 eines Kodiermittels zum Definieren einer bestimmten mechanischen Kodierung für zusammengehörende erste und zweite Modulteile 102, 106. Zwischen dem ersten Teil 192 und dem zweiten Teil 194 ist mindestens eine Trennstelle 193 zum Trennen des ersten Teils 192 und des zweiten Teils 194 vorgesehen. In den gezeigten Ausführungsbeispielen ist and dem zweiten Teil eine sich zur Trennstelle hin verjüngende Brücke vorgesehen. Diese Trennstelle 193 ist vorzugsweise eine Sollbruchstelle. Dies bedeutet, dass der erste Teil 192 und der zweite Teil 194 durch Bruchtrennen voneinander trennbar sind. Der Trennvorgang beinhaltet das Ausüben einer bestimmten Kraft auf die Sollbruchstelle (z.B. durch eine Drehbewegung). Der erste Teil 192 und zweite Teil 194 lassen sich dann "per Hand" voneinander trennen. So kann das separate Zubehörelement 190 in einem Stück gefertigt werden und der erste bzw. zweite Teil 192, 194 können erst dann abgetrennt werden, wenn dies für die spätere Montage erforderlich ist. Es sollte jedoch verstanden werden, dass die Trennstelle auch für andere Trennmethoden ausgelegt sein kann, wie beispielsweise Zerteilen durch einen Schneidvorgang, Sägen, Abtrennen mit einer Kneifzange oder ähnliches.

Die Kodierleiste 170 an dem Gehäuse des einen Modulteils 102 weist mindestens einen darin ausgeformten Kodierhohlraum 172 auf. Ein entsprechender Kodiervorsprung an dem Gehäuse des anderen Modulteils 106 kann in den Kodierhohlraum 172 hineinragen. In anderen Worten sind ein Kodierhohlraum 172 und sein entsprechender Kodiervorsprung 174 derart gegenüberliegend angeordnet, dass im zusammengesetzten Zustand der Kodiervorsprung 174 in den Kodierhohlraum 172 hineinragt. Das heißt, jeweils ein Kodierhohlraum 172 und ein Kodiervorsprung 174 sind einander räumlich zugeordnet. Das Kodiermittel wird dann durch die Kodierleiste und die entsprechenden Kodiervorsprünge gebildet. In den dargestellten Ausführungsbeispielen ist eine Art der mechanischen Kodierung beschrieben, bei der die Kodierleiste 170 mehrere Kodierhohlräume 172 aufweist. Bei dieser Art der mechanischen Kodierung sind mehrere Kodiervorsprünge und mehrere entsprechende Kodierhohlräume vorgesehen. In der zusammengesetzten Anordnung ragt in die Kodierhohlräume 172 jeweils ein Kodiervorsprung hinein. Die Kodierhohlräume 172 sind nebeneinander liegend in einer Reihe in der Kodierleiste 170 ausgeformt. Zwischen jeweils zwei Kodierhohlräumen 172 befindet sich ein Steg 175 oder Materialvorsprung. Die Kodierhohlräume 172 sind jeweils zur Aufnahme eines Kodiereinsatzstückes (in Fig. 1 nicht abgebildet) ausgebildet.

Diese Art der Kodierung wird nun detaillierter anhand der Fig. 2 erläutert. Wie in Fig. 2 zu sehen, hat das erste Modulteil 102 ein erstes Gehäuse 103, und das zweite Modulteil 106 hat ein zweites Gehäuse 107. Das erste Modulteil 102 und das zweite Modulteil 106 sind mechanisch und elektrisch in eine zusammengesetzte Anordnung zusammensetzbar. Eine Grenzfläche G ist zwischen dem ersten Modulteil 102 und dem zweiten Modulteil 106 gebildet. Das erste Modulteil 102 weist die Kodierleiste 170 mit den mehreren Kodierhohlräumen 172 auf. Das zweite Modulteil 106 weist an seinem Gehäuse 107 entsprechende Kodiervorsprünge 174 auf. Ein Kodierhohlraum 172 und sein entsprechender Kodiervorsprung 174 sind derart angeordnet, dass in der zusammengesetzten Anordnung (in Fig. 2 nicht dargestellt) der Kodiervorsprung 174 jeweils in seinen entsprechenden Kodierhohlraum 172 der Kodierleiste 170 hineinragt. Die Kodierleiste 170 mit den Kodierhohlräumen (und Kodiereinsatzstücken) und die entsprechenden Kodiervorsprünge 174 bilden somit das Kodiermittel zum Definieren der bestimmte mechanischen Kodierung für zusammengehörende erste und zweite Modulteile 102, 106.

Die bestimmte Kodierung ist hierbei durch die momentane Anordnung von Kodiereinsatzstücke 180 in den Kodierhohlräumen 172 definiert. Jedes Kodiereinsatzstück 180 füllt seinen Kodierhohlraum 172 derart aus, dass das Hineinragen des Kodiervorsprungs 174 (bzw. des Kodiervorsprungs, der an der dem Kodierhohlraum entsprechenden Position angeordnet ist) in den Kodierhohlraum 172 blockiert werden würde. Es wird so verhindert das nicht zusammengehörende erste und zweite Modulteile zusammengesetzt werden. In dem in Fig. 2 gezeigten Beispiel ist in zwei der Kodierhohlräume 172 jeweils ein Kodiereinsatzstück 180 angeordnet (hier der erste und dritte Kodiervorsprung von links gesehen). Es sollte jedoch verstanden werden, dass abhängig von der jeweiligen Kodierung jede beliebige Anzahl von Kodiereinsatzstücken 180 in den Kodierhohlräumen 172 vorgesehen sein kann. Um die Kodierung vollständig vorzunehmen, wird dann - wie in Fig. 2 gezeigt - der Kodiervorsprung 174, der dem Kodierhohlraum mit eingesetztem Kodiereinsatzstück 180 entspricht bzw. gegenüberliegt, entfernt. Wie in Fig. 2 zu sehen wurden entsprechend zwei Kodiervorsprünge entfernt (der erste und dritte Kodiervorsprung von links bzw. unten gesehen). Die Kodierung wird demnach durch Einsetzen des Kodiereinsatzstückes 180 in einen der Kodierhohlräume 172 und das Entfernen bzw. Abtrennen des Kodiervorsprungs 174, der diesem Kodierhohlraum 172 entspricht, vorgenommen. Auf diese Weise wird die bestimmte Kodierung für zusammengehörende erste und zweite Modulteile 102, 106 definiert. Ist hingegen bei eingesetztem Kodiereinsatzstück 180 der entsprechende Kodiervorsprung 174 weiterhin vorhanden (d.h. nicht entfernt), so wird das Hineinragen des Kodiervorsprungs 174 in den Kodierhohlraum 174, in dem das Kodiereinsatzstück 180 angeordnet ist, blockiert. Die zusammengesetzte Anordnung bzw. das Zusammensetzen des ersten und zweiten Modulteils 102, 106 wird somit verhindert. Auf diese Art kann verhindert werden, dass nicht zusammengehörende erste und zweite Modulteile 102, 106 (d.h. Modulteile mit nicht zusammengehörender mechanischer Kodierung) zusammengesetzt werden.

Es werden bei dieser Art der Kodierung mit n Kodierhohlräumen (n ≥ 2) 2ⁿ verschiedene Kodierungen ermöglicht. In den hier dargestellten Ausführungsbeispielen, wie bspw. in Fig. 1 zu sehen, weist die Kodierleiste 170 acht Kodierhohlräume 172 auf. Es werden somit 256 verschiedene Kodierungen ermöglicht. Es sollte jedoch verstanden werden, dass jede andere Zahl von Kodierhohlräumen vorgesehen sein kann. Bei dieser Art der Kodierung kann der Endbenutzer die Kodierung definieren oder verändern. Zudem müssen die Kodierleiste 170 und die Kodiervorsprünge 172 in nur einer Form bzw. Art hergestellt werden, wodurch die Fertigung sowie die Vorratshaltung billiger und einfacher wird.

Obwohl in den gezeigten Ausführungsbeispielen die soeben beschriebene Art der Kodierung implementiert ist, sollte verstanden werden, dass das separate Zubehörelement bzw. der Modulteil-Bausatz auch für jede andere Art der mechanischen Kodierung geeignet sein kann. Beispielsweise kann die mechanische Kodierung durch die Form bzw. den Querschnitt eines Kodiervorsprungs und seines entsprechenden Kodierhohlraums definiert sein, wobei der Kodierhohlraum eine der Form bzw. Querschnitt des Kodiervorsprungs entsprechende Form bzw. Querschnitt aufweist. Der Kodiervorsprung und sein entsprechender Kodierhohlraum werden dann nach dem Schlüssel-Schlüsselloch-Prinzip zusammengesteckt.

Das mechanische Zusammensetzen der Modulteile 102, 106 wird nun mit Bezug auf Fig. 2 beschrieben. Wie in Fig. 2 ersichtlich, weist das zweite Modulteil 106 ein Schwenkhalterungselement 112 auf, an dem das erste Modulteil 102 lösbar gehalten werden kann bzw. wird. Das Schwenkhalterungselement 112 definiert so einen Schwenkpunkt S mit einer Schwenkachse. Auf diese Weise können das erste Modulteil 102 und das zweite Modulteil 106 durch eine Schwenkbewegung (um den Schwenkpunkt S) entlang einer definierten Bewegungsbahn in die zusammengesetzte Anordnung mechanisch zusammengesetzt werden. Es sollte jedoch verstanden werden, dass jedes andere geeignete Mittel zum mechanischen Zusammensetzen des ersten und zweiten Modulteils 102, 106 vorgesehen sein kann.

Nun wird das elektrische Zusammensetzen der Modulteile 102, 106 mit Bezug auf Fig. 2 beschrieben. Wie in Fig. 2 zu sehen. weist das erste Modulteil 102 erste elektrische Kontakte 122 auf und das zweite Modulteil 106 weist entsprechende elektrische Gegenkontakte 132 auf, die in der ersten zusammengesetzten Anordnung jeweils einen ersten elektrischen Kontakt 122 des ersten Modulteils 102 kontaktieren zur elektrischen Verbindung zwischen dem ersten Modulteil 102 und dem zweiten Modulteil 106. Die ersten elektrischen Kontakte 122 des ersten Modulteils 102 sind hier Leiterbahnen auf einer nichtleitenden Platte, so dass eine Leiterplatte 123 gebildet wird. Die elektrischen Gegenkontakte 132 des zweiten Modulteils 106 sind Kontaktelemente (Pins), die in einem Stecker oder Buchse 133 angeordnet sind. Die Leiterplatte 123 erstreckt sich senkrecht zu der Grenzfläche G zwischen den Modulteilen 102, 106. Die Kodierleiste 170 ist neben bzw. räumlich beanstandet von der Leiterplatte 123 angeordnet, und erstreckt sich insbesondere parallel zu bzw. in der Grenzfläche G. Die Kodiervorsprünge 174 sind neben bzw. räumlich beanstandet von der Buchse 133 angeordnet. Die Leiterplatte 123 kann in den Stecker oder die Buchse 133 eingeführt werden bzw. ist in der zusammengesetzten Anordnung darin eingeführt. Es wird somit eine elektrische Steckverbindung gebildet. Es sollte jedoch verstanden werden, dass jedes andere geeignete Mittel zum elektrischen Zusammensetzen des ersten und zweiten Modulteils 102, 106 vorgesehen sein kann.

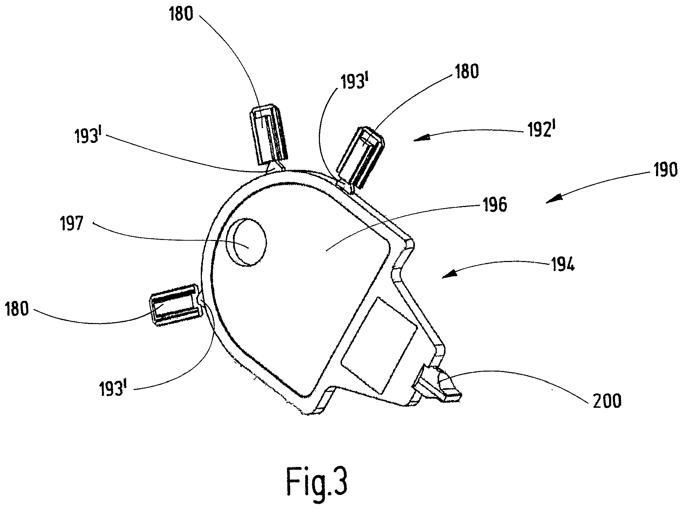

Fig. 3 zeigt eine perspektivische Darstellung eines zweiten Ausführungsbeispiels des separaten Zubehörelements 190. Auch das separate Zubehörelement 190 (Fig. 3) und das erste und zweite Modulteil 102, 106 (Fig. 2) bilden zusammen einen Modulteil-Bausatz. Wie bereits in Bezug auf Fig. 1 erläutert, hat das separate Zubehörelement 190 einen ersten Teil 192' und einen zweiten Teil 194 zum Greifen des separaten Zubehörelements 190. Jedoch hat bzw. ist in diesem Ausführungsbeispiel der Fig. 3 der erste Teil 192' die Kodiereinsatzstücke 180 des Kodiermittels. Zwischen dem ersten Teil 192' und dem zweiten Teil 194 ist mindestens eine Trennstelle 193' zum Trennen des zweiten Teils 194 und des ersten Teils 192' bzw. der Kodierstücke 180 vorgesehen. Insbesondere ist zwischen jedem Kodiereinsatzstück 180 und dem zweiten Teil 194 eine Trennstelle 193' vorgesehen. Diese Trennstelle 193' kann eine Trennstelle sein, wie die in Bezug auf Fig. 1 beschriebene Trennstelle 193. Vorzugsweise ist die Trennstelle 193' eine Sollbruchstelle. Wie oben beschreiben ist bei der hier dargestellten Art der Kodierung jedes Kodiereinsatzstückes 180 jeweils in einen Kodierhohlraum 172 der Kodierleiste 170 einsetzbar.

Die folgenden Erläuterungen treffen sowohl für das erste Ausführungsbeispiel der Fig. 1 als auch das zweite Ausführungsbeispiel der Fig. 3 zu. Gemäß der Erfindung weist der zweite Teil 194 ein Werkzeug mit einem Werkzeuggriffabschnitt 196 und einen Werkzeugkopf 200 auf. Somit ist der zweite Teil 194 des separaten Zubehörelements 190 zum Greifen des Zubehörelements kein Abfall, sondern hat die spezielle Funktion eines Werkzeugs. Dadurch wird weniger Abfall erzeugt und somit eine erhöhte Umweltfreundlichkeit bereitgestellt. Das Werkzeug kann insbesondere für die Modulteile 102, 106 verwendet werden, bspw. bei der Installation oder wenn der Endbenutzer die bestimmte Kodierung definiert. Aber auch nach der Installation bzw. Definition der mechanischen Kodierung kann das Werkzeug weiter verwendet werden.

Sowohl in dem ersten Ausführungsbeispiel der Fig. 1 als auch in dem zweiten Ausführungsbeispiel der Fig. 3 ist der Werkzeugkopf 200 eine Schraubendreherklinge. Insbesondere ist hier eine Schlitzschraubendreherklinge (mit rechteckigem Querschnitt) dargestellt, die in einen Schlitzschraubenkopf eingreifen kann. Es sollte jedoch verstanden werden, dass die Schraubendreherklinge jede andere geeignete Form aufweisen kann, wie beispielsweise eine Kreuzschlitz-, Inbus-, Torxschraubendreherklinge oder ähnliches (d.h. mit kreuzförmigem, sechseckförmigem, sternförmigem Querschnitt oder ähnlichem). Es sollte weiterhin verstanden werden, dass jede andere Art von Werkzeugkopf vorgesehen sein kann, wie beispielsweise ein Messerklinge, ein Sägeblatt, eine Feile oder ähnliches.

In den gezeigten Ausführungsbeispielen ist das separate Zubehörelement 190 in einem Stück spritzgegossen. Es wird so eine einfachere und kostengünstigere Herstellung bereitgestellt. In den gezeigten Ausführungsbeispielen ist der zweite Teil 194 in Form einer Platte ausgebildet ist. Unter einer Platte ist hier insbesondere ein Element oder Teil zu verstehen, dessen Höhe sehr klein im Vergleich zu seiner Breite und Tiefe ist. Bei der Herstellung des separaten Zubehörelements 190 kann so Material gespart werden. Es sollte jedoch verstanden werden, dass das zweite Teil 194 auch in Form eines konventionellen massiven (z.B. zylinderförmigen) Werkzeuggriffs ausgebildet sein kann.

In den gezeigten Ausführungsbeispielen weist der zweite Teil 194 ein Durchgangsloch 197 auf. Das Durchgangsloch 197 ist in dem Werkzeuggriffabschnitt 196 angeordnet. Insbesondere kann der kleinste Abstand vom Durchgangsloch 197 zur Kante des zweiten Teils 194 bzw. des Werkzeuggriffabschnitts 196 derart bemessen sein, dass der zweite Teil 194 bzw. das Werkzeug an einen Schlüsselbund montierbar ist. Ein typischer kleinster Abstand kann hier im Bereich von 1 bis 4 mm liegen. Der Endbenutzer kann so das Werkzeug an seinem Schlüsselbund montieren. Es wird so vermieden, dass das Werkzeug verloren geht und es wird eine verbesserte Handhabung bereitgestellt. Es sollte jedoch verstanden werden, dass das separate Zubehörelement 190 auch ohne das Durchgangsloch 197 ausgebildet sein kann, oder mit einem anderen Befestigungsmittel versehen sein kann, wie beispielsweise einer Klammer, einem Haken oder ähnlichem.

In den gezeigten Ausführungsbeispielen hat jeder Kodierhohlraum 172 die gleiche Form bzw. den gleichen Querschnitt. Auch jedes Kodiereinsatzstück 180 hat in den gezeigten Ausfürhungsbeispielen die gleiche Form bzw. den gleichen Querschnitt. Die Fertigung ist somit einfach. Insbesondere hat jeder Kodierhohlraum 172 einen T-förmigen Querschnitt und jedes Kodiereinsatzstück 180 hat einen T-förmigen Querschnitt. Der Querschnitt des Kodierhohlraums 172 und der Querschnitt des Kodiereinsatzstücks 180 entsprechen einander. So kann das Kodiereinsatzstück 180 in den Kodierhohlraum 172 eingeschoben werden und wird darin gehalten. Auch der Steg 175 zwischen jeweils zwei Kodierhohlräumen 172 hat einen T-förmigen Querschnitt. Der T-förmige Kodierhohlraum 172 hat eine breiteren T-Kopf-Bereich und einen schmaleren T-Hals-Bereich. Der Steg a75 oder MAterialvorsprung zwischen zwei Kodierhohlräumen 172 hat ebenfalls einen breiteren T-Kopf-Bereich und einen schmaleren T-Hals-Bereich. Der T-Kopf-Bereich des Kodierhohlraums 172 ist zwischen zwei T-Hals-Bereichen der Stege 175 angeordnet, und der T-Hals-Bereich des Kodierhohlraums 172 ist zwischen zwei T-Kopf-Bereichen der Stege 175 angeordnet.

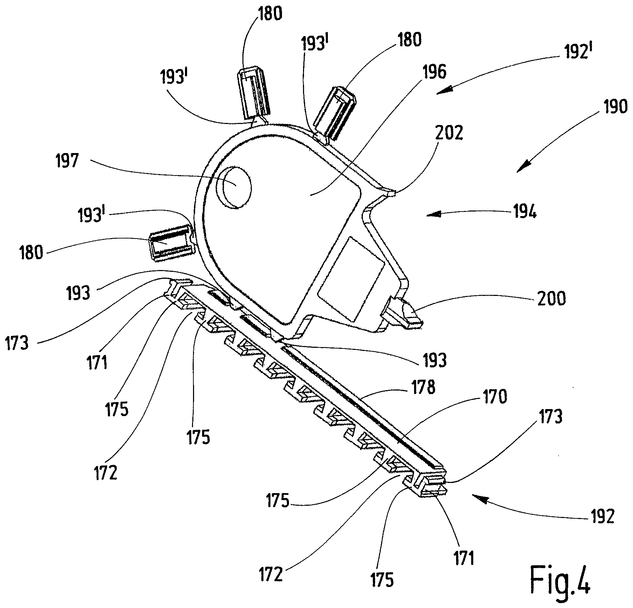

Fig. 4 zeigt eine perspektivische Darstellung eines dritten Ausführungsbeispiels des separaten Zubehörelements 190. Dieses Ausführungsbeispiel basiert auf einer Kombination des ersten Ausführungsbeispiels der Fig. 1 und des zweiten Ausführungsbeispiels der Fig. 3. Die oben genannten Erläuterungen treffen daher ebenso auf das dritte Ausführungsbeispiel der Fig. 3 zu. In dem Ausführungsbeispiel der Fig. 4 weist das separaten Zubehörelement 190 sowohl einen Tei 192 mit der Kodierleiste 170 als auch einen Teil 192' mit den Kodiereinsatzstücke 180 auf. In diesem Ausführungsbeispiel sind die Kodierleiste 170 und die Kodiereinsatzstücke 180 daher in einem Element integriert. Es wird somit die Gefahr des Verlustes eines Teils des Kodiermittels verringert. Des Weiteren wird die Handhabung der meist sehr klein ausgestalteten Kodiereinsatzstücke 180 bzw. der Kodierleiste 170 erleichtert.

In dem Ausführungsbeispiel der Fig. 4 weist das zweite Teil 194 zudem mindestens einen weiteren Werkzeugkopf 202 auf. Auch der weitere Werkzeugkopf 202 weist in diesem Ausführungsbeispiel einen rechteckigen Querschnitt auf. Insofern kann der weitere Werkzeugkopf 202 auch als Schlitzschraubendreherklinge verwendet werden. Jedoch ist der weitere Werkzeugkopf 202 insbesondere dazu ausgelegt eine andere Funktion als der Werkzeugkopf 200 zu erfüllen. Insbesondere sind die Werkzeugköpfe 200, 202 dazu ausgebildet (z.B. aufgrund ihrer Abmessungen und/oder Anordnung) in verschiedene Elemente der Modulteile 102, 106 einzugreifen, wie nachfolgend noch näher erläutert werden wird. Es sollte verstanden werden, dass ein oder mehrere derartige weitere Werkzeugköpfe auch in dem ersten Ausführungsbeispiel der Fig. 1 oder dem zweiten Ausführungsbeispiel der Fig. 3 vorgesehen sein können.

In den gezeigten Ausführungsbeispielen ist die Kodierleiste 170 ein separates Element. Es wird so eine erhöhte Flexibilität bzw. Modularität bereitgestellt. Beispielsweise kann die Kodierleiste 170 auch wieder von dem Modulteil bzw. Gehäuse entfernt werden, wenn keine mechanische Kodierung erwünscht ist. Es ist ein Befestigungsmittel vorgesehen, mittels dessen die Kodierleiste 170 an seinem ersten Modulteil 102 lösbar befestigbar ist. In den gezeigten Ausführungsbeispielen weist das Befestigungsmittel jeweils eine Nase 173 auf den zwei entgegengesetzten Enden der Kodierleiste 170 auf. Die Nasen 173 können jeweils in eine Nut in dem Gehäuse 103 des ersten Modulteils 102 eingreifen. Es sollte jedoch verstanden werden, dass auch jede andere Art der lösbaren Befestigung (beispielsweise eine Klebestelle, Verschraubung oder ähnliches) oder auch eine feste, nicht-lösbare Befestigung vorgesehen sein kann.

In den gezeigten Ausführungsbeispielen sind die Kodiervorsprünge 174 integral mit dem Gehäuse 107 des zweiten Modulteils 106 ausgebildet. Das heißt die Kodiervorsprünge 174 sind hier nicht als separates Element ausgebildet. Insbesondere können die Kodiervorsprünge integral mit dem billigeren der beiden Modulteile ausgebildet sein. Das billigere Modulteil ist beispielsweise das zweite Modulteil 106, das im Gegensatz zu dem ersten Modulteil 102 keine Elektronik aufweist. Bei einem fehlerhaften Abtrennen eines Kodiervorsprungs muss dann nur das billige Teil 106 weggeworfen werden. Es sollte jedoch verstanden werden, dass auch die Kodiervorsprünge 174 auf einer separaten Kodierleiste ausgebildet sein können. Diese kann dann (analog zu der Kodierleiste 170) an dem Gehäuse des zweiten Modulteils 106 angeordnet bzw. (lösbar) befestigt sein.

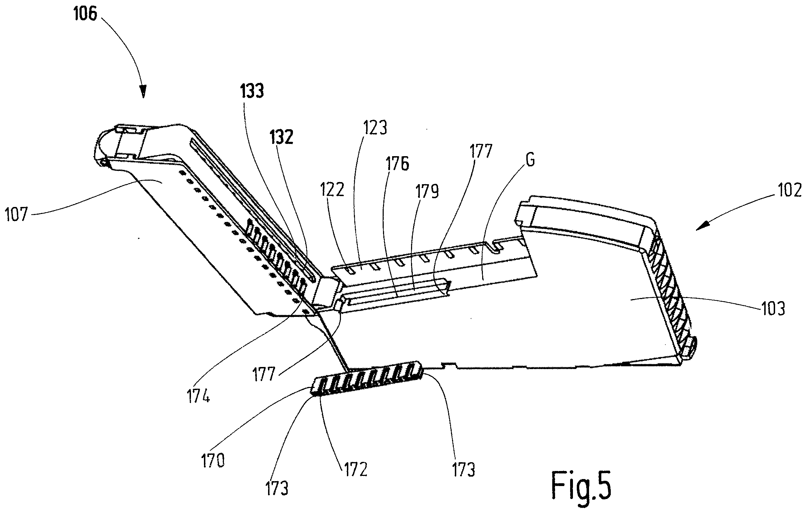

Anhand der Fig. 5 bis Fig. 8 soll nun beispielhaft eine Verwendung des separaten Zubehörelements 190 erläutert werden. Fig. 5 zeigt eine perspektivische Darstellung des Ausführungsbeispiels (siehe Fig. 3) des ersten und zweiten Modulteils 102, 106 mit der Kodierleiste 170 im nicht-eingesetzten Zustand. Die Kodierleiste 170 wurde beispielsweise von dem zweiten Teil 194 des separaten Zubehörelements 190 getrennt, wie in Bezug auf das Ausführungsbeispiel der Fig. 1 erläutert. Das Gehäuse 103 des ersten Modulteils 103 weist eine Aussparung 176 zur Aufnahme der Kodierleiste 170 auf. Die Aussparung 176 hat Abmessungen, die den Abmessungen der Kodierleiste 170 entsprechen. Die Kodierleiste 170 kann so passgenau in die Aussparung 176 eingesetzt werden. Insbesondere hat die Aussparung 176 eine der Kodierleiste 170 entsprechende Höhe. Es wird so eine ebene Grenzfläche G zwischen den Modulteilen 102, 106 ermöglicht. Die Kodierleiste 170 wird in das Gehäuse 103 des ersten Modulteils 102 eingelassen bzw. eingesetzt.

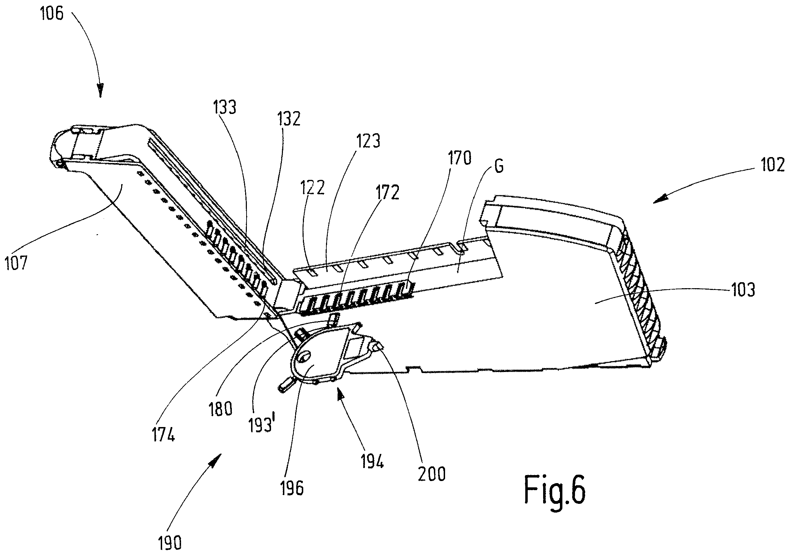

Fig. 6 zeigt eine perspektivische Darstellung des Ausführungsbeispiels des ersten und zweiten Modulteils 102, 106 mit der Kodierleiste 170 im eingesetzten Zustand. Die Kodierleiste ist hier in das Gehäuse 103 bzw. die Aussparung 176 des ersten Modulteils 102 eingesetzt, insbesondere formschlüssig eingesetzt. Es ist vorzugsweise ein Befestigungsmittel vorgesehen, mittels dessen die Kodierleiste 170 in der Aussparung 176 lösbar befestigbar ist. Das Befestigungsmittel der Kodierleiste 170 weist hier die zuvor beschriebenen Nasen 173 auf. Die Aussparung 176 weist Nuten 177 an den zwei entgegengesetzten Enden der Aussparung 176 auf. Die zuvor beschriebenen Nasen 173 der Kodierleiste 170 können jeweils in eine Nut 177 in dem Gehäuse 103 des ersten Modulteils 102 bzw. in der Aussparung 176 eingreifen. Das Befestigungsmittel der Kodierleiste 170 weist des Weiteren elastische Stege 171 an den zwei entgegengesetzten Enden der Kodierleiste auf. Die elastischen Stege 171 sind jeweils am T-Kopf-Bereich der äußersten Stege 175 angeordnet. Jede Nase 173 ist jeweils am Ende eines elastischen Steges 171 angeordnet. Durch Ausüben einer Kraft auf den elastischen Steg 171 kann die Kodierleiste 170 wieder aus der Aussparung 176 entfernt werden. Das Befestigungsmittel der Kodierleiste ist daher in Art einer elastischen und/oder formschlüssigen Klemmung ausgebildet. Des Weiteren weist die Kodierleiste 170 einen hervorstehenden Balken 178 (bzw. hervorstehende Balken) auf, der in eine entsprechende Balkennut 179 (in Fig. 5 zu sehen) in dem Gehäuse 103 bzw. der Aussparung 176 eingreifen kann bzw. eingreift. Es wird so ein Herausrutschen der Kodierleiste 170 aus der Aussparung 176 in einer Richtung parallel zu der Grenzfläche G zwischen den Modulteilen verhindert.

In Fig. 6 ist weiterhin das separate Zubehörelement 190 dargestellt, insbesondere das separate Zubehörelement des Ausführungsbeispiels der Fig. 1 oder der Fig. 4. Wie bereits erläutert wird die bestimmte Kodierung durch die momentane Anordnung von Kodiereinsatzstücke 180 in den Kodierhohlräumen 172 definiert. Wie in Fig. 6 zu sehen kann ein Kodiereinsatzstück 180 durch Greifen des zweiten Teils des separaten Zubehörelements 190 einfach in einen entsprechenden Kodierhohlraum 172 der Kodierleiste 170 eingesetzt werden. Das separate Zubehörelement 190 ermöglicht so eine verbesserte Handhabung der klein ausgestalteten Kodiereinsatzstücke 180. Das Kodiereinsatzstück 180 und das zweite Teil 194 des separaten Zubehörelements 190 können dann durch Ausüben einer bestimmten Kraft (z.B. durch Drehbewegung) auf die als Sollbruchstelle ausgebildete Trennstelle 193' voneinander getrennt werden. Beispielsweise kann das Kodiereinsatzstück 180 in den Kodierhohlraum 172 eingesetzt werden und das zweite Teil 194 kann dann gedreht werden bis eine Trennung erfolgt. Wie bereits erläutert, wird dann der Kodiervorsprung 174, der dem Kodierhohlraum 172 mit eingesetztem Kodiereinsatzstück 180 entspricht bzw. gegenüberliegt, entfernt (wie in Fig. 3 dargestellt).

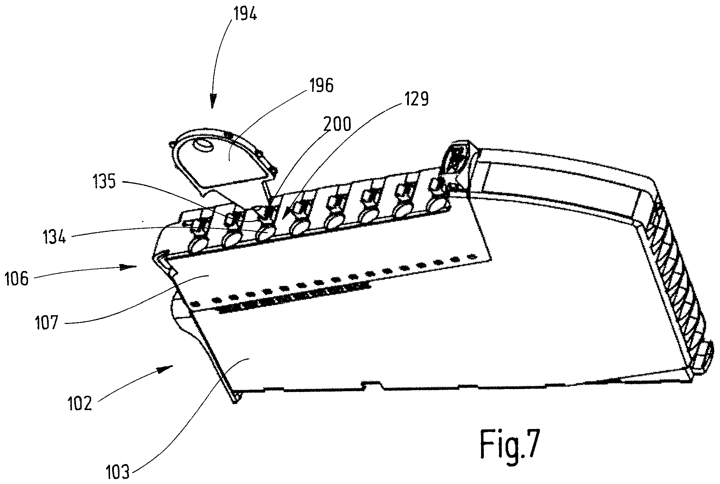

Fig. 7 zeigt eine perspektivische Darstellung eines Ausführungsbeispiels des ersten und zweiten Modulteils 102, 106 in der zusammengesetzten Anordnung. Das erste Modulteil 102 und das zweite Modulteil 106 sind hier elektrisch und mechanisch in die zusammengesetzte Anordnung zusammengesetzt. Fig. 7 zeigt des Weiteren den zweiten Teil 194 des separaten Zubehörelements 190, wie zuvor in Bezug auf Fig. 1 bis Fig. 4 beschrieben. Wie in Fig. 7 zu sehen, ist der Werkzeugkopf 200 des zweiten Teils 194 ausgebildet in ein Befestigungsmittel an dem zweiten Modulteil 106 bzw. dem Gehäuse 107 einzugreifen. Das Werkzeug hat also einen Nutzen an dem Modulteil selber. In Fig. 7 ist das Befestigungsmittel ein Befestigungsmittel 135 eines externen Anschlusses 129 des zweiten Modulteils 106. Der Anschluss 129 ist in dem hier dargestellten Ausführungsbeispiel eine Federzugklemme. Das Befestigungsmittel 135 basiert auf der so genannten (Push-in) Federkraft-Anschlusstechnik. Es sollte jedoch verstanden werden, dass der Anschluss auch jede andere geeignete Art von Anschluss sein kann, wie beispielsweise eine Schraubklemme oder Lüsterklemme. Der externe Anschluss 129 hat ein Loch 134, in das eine Leitung bzw. ein Kabel eingeführt werden kann, sowie das Befestigungsmittel 135, mittels dessen die Leitung bzw. das Kabel in dem Loch 134 festgesetzt werden kann. Das Befestigungsmittel 135 ist im in dem hier dargestellten Ausführungsbeispiel ein Drücker zum Betätigen bzw. Wegdrücken einer Feder. Durch Drücken des Drückers wird die Feder betätigt bzw. weggedrückt und das Kabel kann in das Loch 134 eingeführt werden. Durch Loslassen des Drückers wird das Kabel in dem Loch 134 festgesetzt. Durch Drücken des Drückers kann das Kabel auch wieder gelöst werden. Der Drücker weist eine Einkerbung auf, in die der Werkzeugkopf 200 eingesetzt werden kann. Insbesondere ist die Abmessung bzw. Größe des Werkzeugkopfes 200 derart, dass sie dem Befestigungsmittel 135 entspricht. Der zuvor beschriebene Werkzeugkopf 200 in Form einer Schlitzschraubendreherklinge kann in das Befestigungsmittel 135 eingreifen bzw. eingesetzt werden. Das Werkzeug wird daher dazu benutzt die Leitung bzw. das Kabel an dem externen Anschluss 129 des zweiten Modulteils 106 anzuschließen bzw. zu lösen. Obwohl in dem dargestellten Ausführungsbeispiel der Werkzeugkopf 200 in den Drücker der Federzugklemme eingreift bzw. eingesetzt wird, kann der Werkzeugkopf 200 in anderen Ausführungsbeispielen beispielsweise auch in eine Schraube, insbesondere Schlitzschraube, einer Schraubklemme eingreifen bzw. eingesetzt werden.

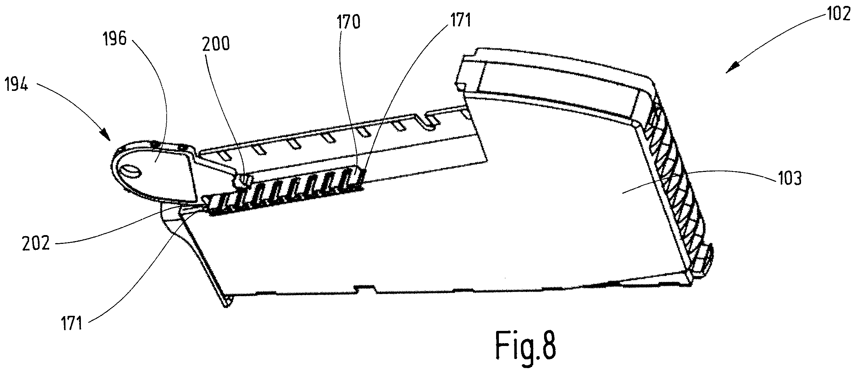

Fig. 8 zeigt eine perspektivische Darstellung des ersten Modulteils 102 des Ausführungsbeispiels. Die Kodierleiste 170 ist an dem Gehäuse 103 des ersten Modulteils 102 angeordnet. Fig. 8 zeigt weiterhin den zweiten Teil 194 des separaten Zubehörelements 190, wie zuvor in Bezug auf Fig. 1 bis Fig. 4 beschrieben. In diesem Beispiel ist der weitere Werkzeugkopf 202 ausgebildet zum Entfernen der Kodierleiste 170 von seinem Modulteil 102. Der weitere Werkzeugkopf ist ausgebildet in das Befestigungsmittel einzugreifen, mittels dessen die Kodierleiste 170 an seinem Modulteil 102 lösbar befestigt ist. Wie in Fig. 8 zu sehen wird der Werkzeugkopf 202 an dem einen Ende der Kodierleiste 170 den elastischen Steg 171 des Befestigungsmittels der Kodierleiste 170 angesetzt. Durch Ausüben einer Kraft auf den elastischen Steg 171 mittels des Werkzeugs kann die Kodierleiste 171 dann wieder aus der Aussparung 176 entfernt werden.

Alternativ oder zusätzlich kann der Werkzeugkopf 200 und/oder der weitere Werkzeugkopf 202 auch dazu benutzt werden das Kodiereinsatzstückes aus seinem Kodierhohlraum zu entfernen. Beispielsweise kann der Werkzeugkopf 200 ausgebildet sein in ein Befestigungsmittel des zweiten Modulteils 106 eingreifen (wie in Bezug auf Fig. 6 beschrieben) und der andere Werkzeugkopf 202 kann ausgebildet sein in ein Befestigungsmittel des ersten Modulteils 102 eingreifen (wie in Bezug auf Fig. 8 beschrieben). Die Werkzeugköpfe 200, 202 können daher dazu ausgebildet sein in verschiedene Elemente der Modulteile 102, 106 einzugreifen.

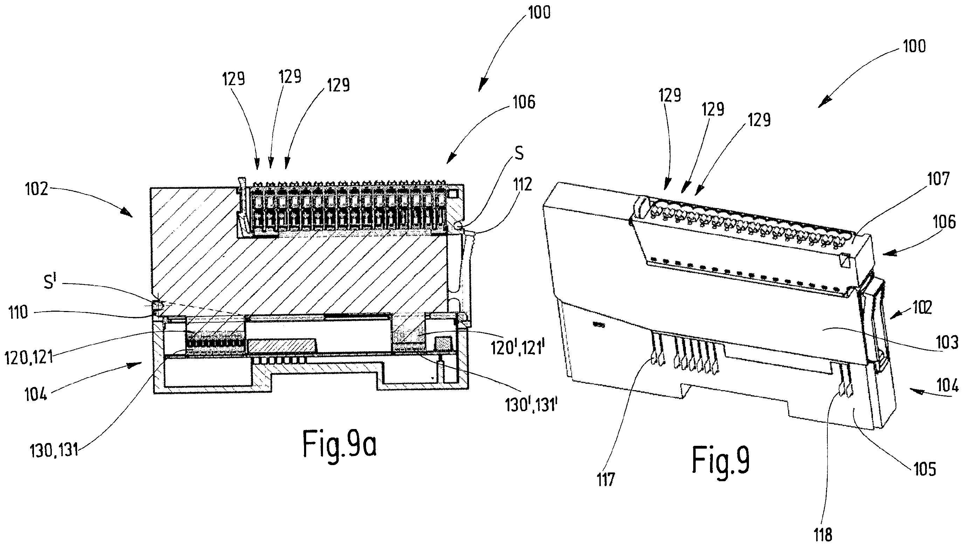

Die hier beschriebene Steuerungsvorrichtung kann insbesondere eine modulare Steuerungsvorrichtung mit zumindest einem Modul mit jeweils mehreren Modulteilen 102, 106 sein. Insbesondere können mehrere nebeneinander angeordnete Module vorgesehen sein. Fig. 9 zeigt eine perspektivische Darstellung eines Ausführungsbeispiels eines Moduls 100 mit dem ersten Modulteil 102, dem zweiten Modulteil 106 und einem weiteren, dritten Modulteil 104. Fig. 9a zeigt eine entsprechende Querschnittsansicht des in Fig. 9 gezeigten Moduls 100. Das erste bzw. zweite Modulteil 102, 104 sind in diesem Ausführungsbeispiel insbesondere das erste bzw. zweite Modulteil, die in Bezug auf die vorhergehenden Figuren erläutert wurden.

In den gezeigten Ausführungsbeispielen weist das erste Modulteil 102 eine in dem ersten Gehäuse 103 angeordneten Elektronik oder Signalverarbeitungseinheit auf. Das zweite Modulteil 106 weist an dem zweiten Gehäuse 107 zumindest einen externen Anschluss 129 zum Anlegen eines Signals oder einer Spannung (von außen bzw. extern) auf. Das heißt, hier hat das erste Modulteil 102 die Funktion eines Elektronikmodulteils und das zweite Modulteil 106 hat die Funktion eines Anschlussmodulteils. In Fig. 9 und Fig. 9a sind eine Mehrzahl von externen Anschlüssen 129 dargestellt, die nebeneinander liegend am Gehäuse 107 des zweiten Modulteils 106 angeordnet sind. In dem dargestellten Ausführungsbeispiel umfasst das zweite Modulteil 106 sechzehn externe Anschlüsse 129, die in einer einzigen Reihe angeordnet sind (16-polig und einreihig). Es sollte jedoch verstanden werden, dass jede andere geeignete Anzahl und Anordnung von externen Anschlüssen vorgesehen sein kann. Ein externer Anschluss kann ein Ausgang zum Übermitteln eines Ausgangssignals (beispielsweise an einen Aktor) oder ein Eingang zum Aufnehmen eines Eingangssignals (beispielsweise von einem Sensor) sein.

In dem in Fig. 9 gezeigten Ausführungsbeispiel umfasst das Modul 100 neben dem ersten und zweiten Modulteil 102, 106 weiterhin das dritte Modulteil 104. Das dritte Modulteil 104 umfasst ein drittes Gehäuse 105. Das dritte Modulteil 104 umfasst zumindest einen Busanschluss 117, 118. Das dritte Modulteil 104 wird daher im Folgenden auch Busmodulteil genannt. Obwohl vorhergehend die mechanische Kodierung zwischen dem ersten Modulteil 102 und dem zweiten Modulteil 106 beschrieben worden ist, sollte verstanden werden, dass alternativ oder zusätzlich die mechanische Kodierung auch zwischen dem ersten Modulteil 102 und dem dritten Modulteil 104 vorgesehen sein kann.

Die dritten Modulteile 104 bzw. die Module 100 können in einer Längsrichtung nebeneinander auf einer Führungsschiene (nicht dargestellt) angeordnet bzw. montiert werden. Das dritte Modulteil (Busmodulteil) 104 weist einen Busanschluss 117 für einen Versorgungsspannungsbus und einen Busanschluss 118 für einen Kommunikationsbus auf. Das dritte Modulteil (Busmodulteil) 104 umfasst einen ersten elektrischen Busanschluss 117, 118 an einer ersten Seite des Gehäuses 105 zur elektrischen Verbindung mit einem in Längsrichtung danebenliegenden Nachbarmodulteil. Das dritte Modulteil (Busmodulteil) 104 umfasst weiterhin einen zweiten elektrischen Busanschluss (in Fig. 9 nicht zu sehen) an einer zweiten, der ersten Seite gegenüberliegenden Seite des Gehäuses 105 zur elektrischen Verbindung mit einem in Längsrichtung danebenliegenden anderen Nachbarmodulteil. Insbesondere kann der zweite elektrische Busanschluss mit dem entsprechenden ersten elektrischen Busanschluss des anderen Nachbarmodulteils verbunden werden. Auf diese Weise wird der Versorgungsspannungsbus und der Kommunikationsbus über die zweiten Modulteile 104 hinweg durchgeschaltet.

Wie bereits in Bezug auf Fig. 2 erläutert, können das erste Modulteil 102 und das zweite Modulteil 106 mechanisch und elektrisch in eine (erste) zusammengesetzte Anordnung zusammengesetzt werden. Auch das erste Modulteil 102 und das dritte Modulteil 104 können mechanisch und elektrisch in eine (zweite) zusammengesetzten Anordnung zusammengesetzt werden. Fig. 9 und Fig. 9a zeigen die Modulteile in der ersten und zweiten zusammengesetzten Anordnung.

Wie bereits in Bezug auf Fig. 2 erläutert, weist das zweite Modulteil 106 ein Schwenkhalterungselement 112 auf, an dem das erste Modulteil 102 lösbar gehalten werden kann bzw. wird. Wie in Fig. 9a ersichtlich, umfasst auch das erste Modulteil (Elektronikmodulteil) 102 ein Schwenkhalterungselement 110, an dem das dritte Modulteil 104 lösbar gehalten werden kann bzw. wird. Das Schwenkhalterungselement 110 definiert so einen Schwenkpunkt S' mit einer Schwenkachse. Auf diese Weise können auch das erste Modulteil 102 und das dritte Modulteil 104 durch eine Schwenkbewegung (um den Schwenkpunkt S') entlang einer definierten Bewegungsbahn in die zweite zusammengesetzte Anordnung zusammengesetzt werden. In dem in Fig. 9a dargestellten Ausführungsbeispiel umfasst das Schwenkhalterungselement 110, 112 jeweils einen Vorsprung (z.B. gekrümmter Vorsprung, Haken oder ähnliches), der in eine Aussparung des entsprechend anderen Modulteils eingreift. Es wird so eine schwenkbare Verbindung bereitgestellt. Die Modulteile können so durch eine einfache Schwenkbewegung um einen fest definierten Schwenkpunkt sicher und zuverlässig zusammengesetzt werden. In dem dargestellten Ausführungsbeispiel sind das Schwenkhaltungselement 110 des ersten Modulteils 102 und das Schwenkhalterungselement 112 des zweiten Modulteils 106 an sich einander gegenüberliegenden Seiten des Moduls 100 angeordnet. Somit ist in das dritte Modulteil 106 in eine erste Richtung (nach rechts in Fig. 9a) abschwenkbar und das erste Modulteils 102 ist in eine zweite, der ersten entgegengesetzte Richtung (nach links in Fig. 9a) abschwenkbar.

Wie bereits in Bezug auf Fig. 2 erläutert, weist das erste Modulteil 102 erste elektrische Kontakte 122 auf und das zweite Modulteil 106 weist entsprechende elektrische Gegenkontakte 132 auf zur elektrischen Verbindung zwischen dem ersten Modulteil 102 und dem zweiten Modulteil 106. Das erste Modulteil 102 weist weiterhin zweite elektrische Kontakte 120 auf und das dritte Modulteil 104 weist elektrische Gegenkontakte 130, die in der zweiten zusammengesetzten Anordnung jeweils einen elektrischen Kontakt 120 kontaktieren zur elektrischen Verbindung zwischen dem ersten Modulteil 102 und dem dritten Modulteil 104. Die zweiten elektrischen Kontakte 120 des ersten Modulteils 102 sind hier ebenfalls Leiterbahnen auf einer nichtleitenden Platte, so dass eine Leiterplatte 121 gebildet wird. Die elektrischen Gegenkontakte 130 des zweiten Modulteils 106 sind Kontaktelemente (Pins), die in einem Stecker oder Buchse 131 angeordnet sind. Die Leiterplatte 121 kann in den Stecker oder die Buchse 131 eingeführt werden bzw. ist in der zusammengesetzten Anordnung darin eingeführt. Es wird somit eine elektrische Steckverbindung gebildet.

Wie in Fig. 9 und Fig. 9a zu sehen, bilden die Kontakte 120 und die entsprechenden Gegenkontakte 130 eine erste Gruppe. In diesem Ausführungsbeispiel dient die erste Gruppe dazu, die Spannung oder das Signal des Kommunikationsbuses, der mittels der Busanschlüsse 117 durchgeschaltet wird, von dem zweiten Modulteil (Busmodulteil) 104 auf das erste Modulteil (Elektronikmodulteil) 102 zu übertragen. Es ist weiterhin eine zweite Gruppe von Kontakten 120' auf einer entsprechenden Leiterplatte 121' vorgesehen, sowie entsprechende Gegenkontakte 130' in einem Stecker oder Buchse 131', wie bereits in Bezug auf die Kontakte 120 und Gegenkontakte 130 beschrieben. In diesem Ausführungsbeispiel dient die zweite Gruppe der Kontakte 120' bzw. Gegenkontakte 130' dazu, die Spannung des Versorgungsspannungsbuses, der mittels der Busanschlüsse 118 durchgeschaltet wird, von dem zweiten Modulteil (Busmodulteil) 104 auf das erste Modulteil (Elektronikmodulteil) 102 zu übertragen.

Die Steuerungsvorrichtung 1 kann weiterhin ein Kopfmodul (nicht dargestellt) umfassen, das Schnittstellen und ein Verarbeitungsteil umfasst, insbesondere zur Koordination des Datenverkehrs auf dem (Kommunikations-)Bus. Das Kopfmodul kann dann ebenfalls auf der Führungsschiene montiert sein bzw. werden. Das Kopfmodul kann in Längsrichtung neben den Modulen 100, wie oben beschrieben, angeordnet sein. Das Kopfmodul kann beispielsweise über den ersten Busanschluss 117, 118 mit den Modulen verbunden sein. Jedes Modul 100, bzw. das entsprechende erste Modulteil (Elektronikmodulteil) 102, kann ein E/A(Ein- /Ausgabe)-Modul bzw. Modulteil sein. Das E/A-Modul bzw. Modulteil kann ein fehlersicheres Modul (Fail-safe bzw. FS) oder ein nicht-fehlersicheres Standardmodul (ST) sein. Beispielhaft für eine solche Realisierung sei auf WO 2005/003869 A1 verwiesen.

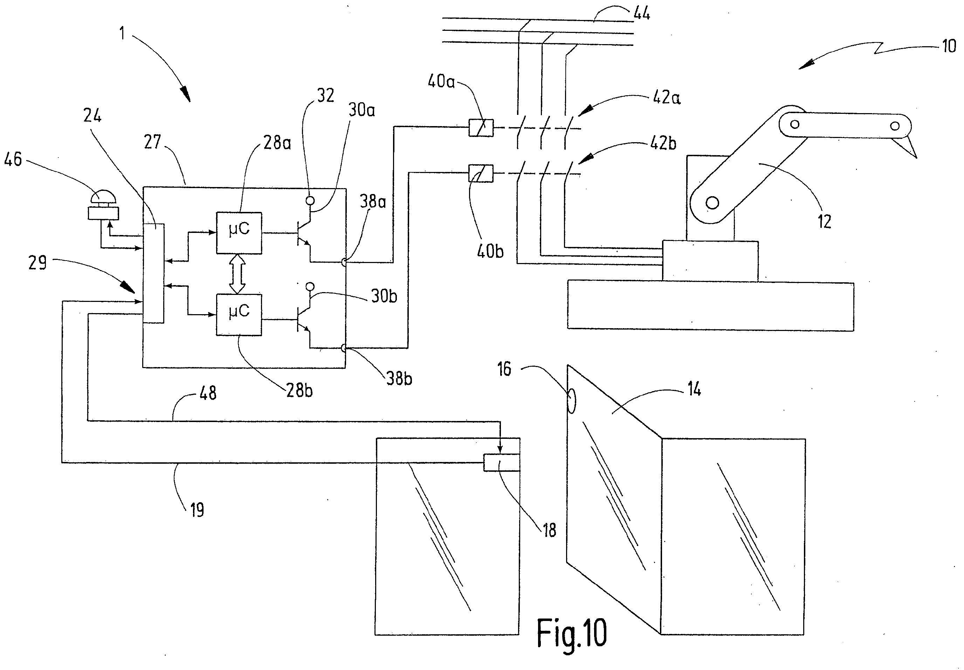

Fig. 10 zeigt eine vereinfachte Darstellung einer technischen Anlage 10 mit einem Ausführungsbeispiel der Steuerungsvorrichtung 1 zum automatisierten Steuern der technischen Anlage 10 dargestellt. In diesem Ausführungsbeispiel ist die Steuerungsvorrichtung 1 geeignet zum fehlersicheren Abschalten der Anlage 10, d.h. die Steuerungsvorrichtung 1 wird für Sicherheitsaufgaben verwendet. Die Anlage 10 beinhaltet hier beispielhaft einen Roboter 12, von dessen Bewegungen im Arbeitsbetrieb eine Gefahr für Personen ausgeht, die sich im Arbeitsbereich des Roboters 12 aufhalten. Aus diesem Grund ist der Arbeitsbereich des Roboters 12 mit einem Schutzzaun mit einer Schutztür 14 abgesichert. Die Schutztür 14 ermöglicht den Zugang in den Arbeitsbereich des Roboters 12, beispielsweise für Wartungsarbeiten oder für Einrichtarbeiten. Im normalen Arbeitsbetrieb darf der Roboter 12 jedoch nur arbeiten, wenn die Schutztür 14 geschlossen ist. Sobald die Schutztür 14 geöffnet wird, muss der Roboter 12 abgeschaltet werden oder auf andere Weise in einen sicheren Zustand gebracht werden.

Um den geschlossenen Zustand der Schutztür 14 zu detektieren, ist an der Schutztür 14 ein Schutztürschalter mit einem Türteil 16 und einem Rahmenteil 18 angebracht. Das Rahmenteil 18 erzeugt auf einer Leitung 19 ein Schutztürsignal, das über die Leitung 19 der neuen Steuerungsvorrichtung 1 zugeführt ist.

Die Steuerungsvorrichtung 1 besitzt in diesem Ausführungsbeispiel einen E/A-Teil 24 mit einer Vielzahl von Anschlüssen (bzw. externen oder Geräteanschlüssen) 29. In einigen Ausführungsbeispielen sind die Anschlüsse 29 Anschlussklemmen oder Feldklemmen, die an einer Gehäuseseite des Gehäuses 27 der Steuerungsvorrichtung 1 angeordnet sind, beispielsweise an einem Anschlussmodulteil, wie zuvor erklärt. Die Anschlüsse 29 können insbesondere die zuvor beschriebenen Anschlüsse 129 sein oder umfassen. Beispielsweise kann es sich um Federzugklemmen oder um Schraubklemmen handeln. In anderen Ausführungsbeispielen können die Anschlüsse Stecker oder Buchsen sein, die mehrere Kontaktelemente (Pins) beinhalten, wobei jeweils ein Pin einen Anschluss bildet. Häufig werden M8-Buchsen mit fünf Kontaktpins für den Anschluss von Meldegeräten oder anderen Sensoren auf Feldebene verwendet. Dementsprechend können Ausführungsbeispiele der neuen Steuerungsvorrichtung Feldgeräte sein oder umfassen, die außerhalb eines Schaltschranks in räumlicher Nähe zu dem Roboter 12 angeordnet sind.

Die Steuerungsvorrichtung 1 besitzt in diesem Ausführungsbeispiel zwei redundante Signalverarbeitungskanäle. Beispielhaft sind hier zwei Mikrokontroller 28a, 28b dargestellt, die jeweils mit dem E/A-Teil 24 verbunden sind. Die Mikrokontroller 28a, 28b verarbeiten hier redundant zueinander die Eingangssignale, die die Steuerungsvorrichtung 1 an den Geräteanschlüssen des E/A-Teils 24 aufnimmt, und sie vergleichen ihre Ergebnisse, was mit einem Pfeil 29 dargestellt ist. Anstelle von zwei Mikrokontrollern 28a, 28b können Mikroprozessoren, ASICs, FPGAs und/oder andere Signalverarbeitungsschaltkreise verwendet sein. Bevorzugt besitzen Ausführungsbeispiele der Steuerungsvorrichtung 1 zumindest zwei zueinander redundante Signalverarbeitungskanäle, die jeweils in der Lage sind, logische Signalverknüpfungen vorzunehmen, um in Abhängigkeit davon ein Signal zu erzeugen. Dieses Signal wird dann verwendet, um ein Schaltelement zum Abschalten des Roboters 12 anzusteuern. Eine solche Steuerungsvorrichtung 1 kann dann zum fehlersicheren (FS) Abschalten der Anlage 10, hier des Roboters 12, verwendet werden.

In dem hier dargestellten Fall besitzt die Steuerungsvorrichtung 1 zwei redundante Schaltelemente 30a, 30b. Jedes dieser beiden Schaltelemente ist in der Lage, ein hohes Spannungspotential 32 zu einem Geräteanschluss 38a, 38b der Steuervorrichtung 1 durchzuschalten, um einen Stromfluss zu einem Schütz 40a, 40b zu ermöglichen, oder diesen Stromfluss zu unterbrechen. Damit kann jedes der Schaltelemente 30 einen Aktor, wie einen Schütz oder ein Magnetventil, abschalten.

Die Schütze 40a, 40b besitzen jeweils Arbeitskontakte 42a, 42b. Die Arbeitskontakte 42a, 42b sind hier in Reihe zueinander in einen Stromversorgungspfad von einer Stromversorgung 44 zu dem Roboter 12 angeordnet. Sobald die Steuervorrichtung 1 die Schütze 40a, 40b abschaltet, fallen die Kontakte 42 ab und die Stromversorgung für den Roboter 12 wird abgeschaltet. Den einschlägigen Fachleuten ist klar, dass eine solche "radikale" Abschaltung hier beispielhaft beschrieben ist. Abweichend hiervon können bei einer Sicherheitsanforderung lediglich Teile des Roboters 12 abgeschaltet werden, wie etwa die gefährlichen Antriebe, während andere Teile des Roboters 12 funktionsbereit bleiben. Auch ein verzögertes Abschalten ist denkbar, damit der Roboter 12 ggf. vor dem Abschalten der Antriebe kontrolliert abgebremst werden kann.

Die Steuervorrichtung 1 steuert die Schaltelemente 30a, 30b hier in Abhängigkeit von dem Signal des Schutztürschalters auf der Leitung 19 und in Abhängigkeit von einem weiteren Eingangssignal von einem Not-Aus-Taster 46 an. Auch der Not-Aus-Taster 46 ist über Leitungen mit Geräteanschlüssen der Steuervorrichtung 1 verbunden. Bevorzugt kann jedes der Eingangssignale redundant anliegen bzw. es können jeweils zwei Eingangs- und Ausgangsleitungen oder Anschlüsse vorgesehen sein (in Fig. 10 nicht dargestellt). In dem in Fig. 10 gezeigten Beispiel können also für den Not-Aus-Taster 46 zwei Eingangsleitungen oder Eingänge vorgesehen sein, die jeweils ein Eingangssignal von dem Not-Aus- Taster 46 liefern. Ähnliches gilt für das Signal des Schutztürschalters.

In einigen Ausführungsbeispielen erzeugt die Steuervorrichtung 1 Ausgangssignale, die den einzelnen Meldegeräten zugeführt sind. Beispielhaft ist ein solches Ausgangssignal über eine Leitung 48 zu dem Rahmenteil 18 des Schutztürschalters geführt. Das Rahmenteil 18 schleift das Ausgangssignal des Sicherheitsschaltgerätes 1 von der Leitung 48 auf die Leitung 19, wenn sich das Türteil 16 in der Nähe des Rahmenteils 18 befindet, das heißt wenn die Schutztür 14 geschlossen ist. Daher kann die Steuervorrichtung 1 den Schutztürschalter mit Hilfe des Ausgangssignals auf der Leitung 48 und mit Hilfe des Eingangssignals auf der Leitung 19 überwachen. In vergleichbarer Weise überwacht die Steuervorrichtung 1 hier den Not-Aus-Taster 46.

Abweichend von der Darstellung in Fig. 10 werden in der Praxis häufig zwei redundante Ausgangssignale der Steuervorrichtung 1 verwendet, die jeweils über eine separate Signalleitung zu einem Meldegerät geführt sind und über dieses Meldegerät zurück zur Steuervorrichtung 1 geschleift sind. Beispielhaft für eine solche Realisierung sei auf DE 10 2004 020 995 A1 verwiesen, die hinsichtlich der Details einer solchen redundanten Überwachung eines Meldegerätes durch Bezugnahme aufgenommen ist. Auch der Not-Aus-Taster 46 wird in der Praxis häufig mit redundanten Eingangs- und Ausgangsleitungen überwacht, wie oben erwähnt.

In dem in Fig. 10 dargestellten Ausführungsbeispiel der Steuerungsvorrichtung 1 wird die Steuerungsvorrichtung für Sicherheitsaufgaben verwendet, insbesondere zum fehlersicheren (FS) Abschalten einer Anlage. Es sollte jedoch verstanden werden, dass die Steuerungsvorrichtung 1 auch für nichtsicherheitsgerichtete Aufgaben bzw. Standardaufgaben (ST) verwendet werden kann.

Die Steuerungsvorrichtung 1 kann insbesondere eine programmierbare Steuerungsvorrichtung für eine programmierbare Steuerung der technischen Anlage sein. Alternativ kann die Steuervorrichtung 1 auch eine konfigurierbare Steuerungsvorrichtung sein. Unter konfigurierbar ist hier das Anpassen oder Einstellen eines Hardwarebestandteils der Steuerung zu verstehen, wie beispielsweise einer Verdrahtung. Unter programmierbar ist hier das Anpassen oder Einstellen eines Softwarebestandteils der Steuerung zu verstehen, beispielsweise mittels einer Programmiersprache.

Die Steuervorrichtung 1 kann zumindest einen Bus umfassen, insbesondere einen Kommunikationsbus und/oder Versorgungsspannungsbus. Beispielsweise kann die Steuerungsvorrichtung 1 eine dezentrale Steuerungsvorrichtung sein, deren Komponenten über einen Bus miteinander verbunden sind. Die Steuerungsvorrichtung kann insbesondere ein Kopfmodul umfassen zur Koordination des Datenverkehrs auf dem (Kommunikations-)Bus. Bei einer Steuerungsvorrichtung 1 für Sicherheitsaufgaben kann der (Kommunikations-)Bus beispielsweise ein fehlersicherer Bus wie SafetyBUS p oder PROFINET sein. Bei einer Steuerungsvorrichtung 1 für Standardaufgaben kann der Bus beispielsweise ein Standardfeldbus wie CANOpen oder DeviceNet oder Ähnliches sein.

## Patentansprüche

1. Separates Zubehörelement (190) für eine zumindest ein erstes und zweites Modulteil (102, 106) aufweisende Steuerungsvorrichtung (1) zum automatisierten Steuern einer technischen Anlage (10), mit einem ersten Teil (192) mit einer Kodierleiste (170) eines Kodiermittels zum Definieren einer bestimmten mechanischen Kodierung für zusammengehörende erste und zweite Modulteile, und mit einem zweiten Teil (194) zum Greifen des separaten Zubehörelements (190), wobei die Kodierleiste (170) mindestens einen darin ausgeformten Kodierhohlraum (172) aufweist, wobei zwischen dem ersten Teil (192) und dem zweiten Teil (194) mindestens eine Trennstelle (193) zum Trennen des ersten Teils (192) und des zweiten Teils (194) angeordnet ist, **dadurch gekennzeichnet, dass** der zweite Teil (194) ein Werkzeug mit einem Werkzeuggriffabschnitt (196) und einer Schraubendreherklinge (200) aufweist.

2. Separates Zubehörelement nach Anspruch 1, wobei die Kodierhohlräume (172) jeweils zur Aufnahme eines Kodiereinsatzstückes (180) ausgebildet sind, wobei die bestimmte mechanische Kodierung durch die momentane Anordnung der Kodiereineinsatzstücke (180) in den Kodierhohlräumen (172) definiert ist.

3. Separates Zubehörelement nach Anspruch 2, wobei das separate Zubehörelement (190) die Kodiereinsatzstücke (180) aufweist, und wobei zwischen dem zweiten Teil (194) und den Kodiereinsatzstücken (180) mindestens eine Trennstelle (193') zum Trennen des zweiten Teils (194) und der Kodiereinsatzstücke (180) angeordnet ist.

4. Separates Zubehörelement nach einem der Ansprüche 1 bis 3, wobei der zweite Teil (194) mindestens einen weiteren Werkzeugkopf (202) aufweist.

5. Separates Zubehörelement nach einem der Ansprüche 1 bis 4, wobei der zweite Teil (194) in Form einer Platte ausgebildet ist.

6. Separates Zubehörelement nach einem der Ansprüche 1 bis 5, ferner mit einem Befestigungsmittel, mittels dessen die Kodierleiste (170) an einem Modulteil lösbar befestigbar ist.

7. Separates Zubehörelement nach einem der Ansprüche 1 bis 6, wobei das separate Zubehörelement (190) in einem Stück spritzgegossen ist.

8. Separates Zubehörelement (190), insbesondere nach einem der vorhergehenden Ansprüche, für eine zumindest ein erstes und zweites Modulteil (102, 106) aufweisende Steuerungsvorrichtung (1) zum automatisierten Steuern einer technischen Anlage (10), mit einem ersten Teil (192) mit Kodiereinsatzstücken (180) eines Kodiermittels zum Definieren einer bestimmten mechanischen Kodierung für zusammengehörende erste und zweite Modulteile, und mit einem zweiten Teil (194) zum Greifen des separaten Zubehörelements (190), wobei die Kodiereinsatzstücke (180) jeweils in einen Kodierhohlraum einer Kodierleiste (170) einsetzbar sind, wobei zwischen dem ersten Teil (192) und dem zweiten Teil (194) mindestens eine Trennstelle (193) zum Trennen des ersten Teils (192) und des zweiten Teils (194) angeordnet ist, **dadurch gekennzeichnet, dass** der zweite Teil (194) ein Werkzeug mit einem Werkzeuggriffabschnitt (196) und einer Schraubendreherklinge (200) aufweist.

9. Modulteil-Bausatz für eine Steuerungsvorrichtung (1) zum automatisierten Steuern einer technischen Anlage (10), mit dem separaten Zubehörelement (190) nach einem der vorhergehenden Ansprüche, mit dem ersten Modulteil (102) mit einem ersten Gehäuse (103), und mit dem zweiten Modulteil (106) mit einem zweiten Gehäuse (107), wobei das erste Modulteil (106) und das zweite Modulteil (107) mechanisch und elektrisch in eine zusammengesetzte Anordnung zusammensetzbar sind, wobei eines der Modulteile (102, 106) in der zusammengesetzten Anordnung an seinem Gehäuse (103, 107) eine Kodierleiste (170) mit einem Kodierhohlraum aufweist, wobei das andere Modulteil (102, 106) in der zusammengesetzten Anordnung an seinem Gehäuse (103, 107) mindestens einen Kodiervorsprung (174) aufweist, wobei der mindestens eine Kodiervorsprung (174) in der zusammengesetzten Anordnung jeweils in einen entsprechenden Kodierhohlraum (172) der Kodierleiste (170) hineinragt.

10. Modulteil-Bausatz nach Anspruch 9, wobei der mindestens eine Kodiervorsprung (174) integral mit dem Gehäuse (103, 107) ausgebildet sind.

11. Modulteil-Bausatz nach Anspruch 9 oder 10, wobei das Gehäuse (103, 107) des Modulteils mit der Kodierleiste (170) eine Aussparung (176) zur Aufnahme der Kodierleiste (170) aufweist.

12. Modulteil-Bausatz nach einem der Ansprüche 9 bis 11, wobei das erste Modulteil (102) eine in dem ersten Gehäuse (103) angeordneten Elektronik oder Signalverarbeitungseinheit aufweist und/oder wobei das zweite Modulteil (104) an dem zweiten Gehäuse (107) zumindest einen externen Anschluss zum Anlegen eines Signals oder einer Spannung aufweist.

13. Steuerungsvorrichtung (1) zum automatisierten Steuern einer technischen Anlage (10), mit dem Modulteil-Bausatz nach einem der Ansprüche 9 bis 12.

## Claims

1. A separate accessory element (190) for a control apparatus (1) for automated control of a technical installation (10), said control apparatus comprising at least a first and a second module part (102, 106), comprising a first part (192) having a coding strip (170) of a coding means for defining a defined mechanical coding for mating first and second module parts, and comprising a second part (194) for gripping the separate accessory element (190), wherein the coding strip (170) comprises at least one coding cavity (172) formed therein, wherein at least one disconnection point (193) for disconnecting the first part (192) and the second part (194) from each other is arranged between the first part (192) and the second part (194), **characterized in that** the second part (194) comprises a tool having a tool grip section (196) and a screw driver blade (200).

2. A separate accessory element according to claim 1, wherein the coding cavities (172) are respectively configured for receiving a coding insert (180), wherein the defined mechanical coding is defined by the instantaneous arrangement of the coding inserts (180) in the coding cavities (172).

3. The separate accessory element according to claim 2, wherein the separate accessory element (190) comprises the coding inserts (180), and wherein at least one disconnection point (193') for disconnecting the second part (194) and the coding inserts (180) from each other is arranged between the second part (194) and the coding inserts (180).

4. The separate accessory element according to one of claims 1 to 3, wherein the second part (194) comprises at least one further tool head (202).

5. The separate accessory element according to one of claims 1 to 4, wherein the second part (194) is formed as a plate.

6. The separate accessory element according to one of claims 1 to 5, further comprising a fastening means, via which the coding strip (170) can be releasably fastened on a module part.

7. The separate accessory element according to one of claims 1 to 6, wherein the separate accessory element (190) is injection-molded in one piece.

8. A separate accessory element (190), in particular according to one of the preceding claims, for a control apparatus (1) for automated control of a technical installation (10), the control apparatus comprising at least a first and a second module part (102, 106), comprising a first part (192) having coding inserts (180) of a coding means for defining a defined mechanical coding for mating first and second module parts, and comprising a second part (194) for gripping the separate accessory element (190), wherein the coding inserts (180) can respectively be inserted into a coding cavity of a coding strip (170), wherein at least one disconnection point (193) for disconnecting the first part (192) und the second part (194) from each other is arranged between the first part (192) and the second part (194), **characterized in that** the second part (194) comprises a tool having a tool grip section (196) and a screw driver blade (200).

9. A module part-kit for a control apparatus (1) for automated control of a technical installation (10), comprising the separate accessory element (190) according to one of the preceding claims, comprising the first module part (102) having a first housing (103), and comprising the second module part (106) having a second housing (107), wherein the first module part (106) and the second module part (107) can be mechanically and electrically combined into a combined arrangement, wherein one of the module parts (102, 106) comprises a coding strip (170) having a coding cavity on its housing (103, 107) in the combined arrangement, wherein the other module part (102, 106) comprises at least one coding projection (174) on its housing (103, 107) in the combined arrangement, wherein the at least one coding projection (174) respectively projects into a corresponding coding cavity (172) of the coding strip (170) in the combined arrangement.

10. The module part-kit according to claim 9, wherein the at least one coding projection (174) is integrally formed with the housing (103, 107).

11. The module part-kit according to claim 9 or 10, wherein the housing (103, 107) of the module part having the coding strip (170) comprises a recess (176) for receiving the coding strip (170).

12. The module part-kit according to one of claims 9 to 11, wherein the first module part (102) comprises an electronic or signal processing unit arranged in the first housing (103), and/or wherein the second module part (104) comprises at least one external connector on the second housing (107) for supplying a signal or a voltage.

13. A control apparatus (1) for automated control of a technical installation (10), comprising the module part-kit according to one of claims 9 to 12.

## Revendications

1. Élément accessoire séparé (190) pour un dispositif de commande (1) comportant au moins une première et une deuxième parties de module (102, 106) destinés à commander automatiquement une installation technique (10), comportant une première partie (192) pourvue d'une bande codeuse (170) d'un moyen codeur destiné à définir un codage mécanique spécifique pour des première et deuxième parties de modules associées et comportant une deuxième partie (194) destinée à saisir l'élément accessoire séparé (190), dans lequel la bande codeuse (170) comporte au moins une cavité codeuse (172) formée dans celle-ci, dans lequel au moins un point de séparation (193) destiné à séparer la première partie (192) et la deuxième partie (194) est disposé entre la première partie (192) et la deuxième partie (194), **caractérisé en ce que** la deuxième partie (194) comporte un outil comprenant une partie formant poignée d'outil (196) et une lame de tournevis (200).

2. Élément accessoire séparé selon la revendication 1, dans lequel les cavités codeuses (172) sont conçues pour recevoir chacune une pièce d'insertion codeuse (180), dans lequel le codage mécanique spécifique est défini par l'agencement instantané des pièces d'insertion codeuses (180) dans les cavités codeuses (172).

3. Élément accessoire séparé selon la revendication 2, dans lequel l'élément accessoire séparé (190) comporte les pièces d'insertion codeuses (180), et dans lequel au moins un point de séparation (193') destiné à séparer la deuxième partie (194) et les pièces d'insertion codeuses (180) est disposé entre la deuxième partie (194) et les pièces d'insertion codeuses (180).

4. Élément accessoire séparé selon l'une des revendications 1 à 3, dans lequel la deuxième partie (194) comporte au moins une autre tête d'outil (202).

5. Élément accessoire séparé selon l'une des revendications 1 à 4, dans lequel la deuxième partie (194) est réalisée sous la forme d'une plaque.

6. Élément accessoire séparé selon l'une des revendications 1 à 5, comportant en outre un moyen de fixation au moyen duquel la bande codeuse (170) peut être fixée de manière amovible à une partie de module.

7. Élément accessoire séparé selon l'une des revendications 1 à 6, dans lequel l'élément accessoire séparé (190) est moulé par injection en une pièce.

8. Élément accessoire séparé (190), notamment selon l'une des revendications précédentes, destiné à un dispositif de commande (1) comportant au moins une première et une deuxième parties de module (102, 106) destinées à commander automatiquement une installation technique (10), comportant une première partie (192) pourvue de pièces d'insertion codeuses (180) d'un moyen de codage destiné à définir un codage mécanique spécifique pour des première et deuxième parties de modules associées, et comportant une deuxième partie (194) destinée à saisir l'élément accessoire séparé (190), dans lequel les pièces d'insertion codeuses (180) peuvent être insérées chacune dans une cavité codeuse d'une bande codeuse (170), dans lequel au moins un point de séparation (193) destiné à séparer la première partie (192) et la deuxième partie (194) est disposé entre la première partie (192) et la deuxième partie (194), **caractérisé en ce que** la deuxième partie (194) comporte un outil comprenant une partie formant poignée d'outil (196) et une lame de tournevis (200).

9. Kit de parties de modules pour un dispositif de commande (1) destiné à commander automatiquement une installation technique (10), comportant l'élément accessoire séparé (190) selon l'une des revendications précédentes, comportant la première partie de module (102) pourvue d'un premier boîtier (103) et comportant la deuxième partie de module (106) pourvue d'un deuxième boîtier (107), dans lequel la première partie de module (106) et la deuxième partie de module (107) peuvent être assemblées mécaniquement et électriquement en un agencement assemblé, dans lequel l'une des parties de modules (102, 106) de l'agencement assemblé comporte sur son boîtier (103, 107) une bande codeuse (170) pourvue d'une cavité codeuse, dans lequel l'autre partie de module (102, 106) comporte sur son boîtier (103, 107) au moins une protubérance codeuse (174) dans l'agencement assemblé, dans lequel ladite au moins une protubérance codeuse (174) dans l'agencement assemblé fait respectivement saillie dans une cavité codeuse (172) correspondante de la bande codeuse (170).

10. Kit de parties de modules selon la revendication 9, dans lequel ladite au moins une protubérance codeuse (174) est formée de manière solidaire avec le boîtier (103, 107).

11. Kit de parties de modules selon la revendication 9 ou 10, dans lequel le boîtier (103, 107) de la partie de module pourvue de la bande codeuse (170) présente un évidement (176) destiné à recevoir la bande codeuse (170).

12. Kit de parties de modules selon l'une des revendications 9 à 11, dans lequel la première partie de module (102) comporte une unité électronique ou une unité de traitement de signaux disposée dans le premier boîtier (103) et/ou dans lequel la deuxième partie de module (104) comporte sur le deuxième boîtier (107) au moins un connecteur externe destiné à appliquer un signal ou une tension.

13. Dispositif de commande (1) destiné à commander automatiquement une installation technique (10), comprenant le kit de parties de modules selon l'une des revendications 9 à 12.
